(19) Europäisches Patentamt / European Patent Office / Office européen des brevets

(11) **EP 4 686 952 A1**

(12) **EUROPEAN PATENT APPLICATION**

(43) Date of publication:
04.02.2026 Bulletin 2026/06

(21) Application number: 25181550.2

(22) Date of filing: 09.06.2025

(51) International Patent Classification (IPC):
*G01R 31/327* (2006.01)

(52) Cooperative Patent Classification (CPC):
**G01R 31/3274;** G01R 31/392

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **30.07.2024 KR 20240100982**

(71) Applicant: **SAMSUNG SDI CO., LTD.
Yongin-si, Gyeonggi-do 17084 (KR)**

(72) Inventor: **SIM, Se Sub
16678 Suwon-si (KR)**

(74) Representative: **Marks & Clerk LLP
15 Fetter Lane
London EC4A 1BW (GB)**

(54) **CONTACTOR DIAGNOSIS DEVICE AND METHOD, AND BATTERY MANAGEMENT SYSTEM**

(57) The present disclosure relates to a contactor diagnosis device and method, and is directed to proposing a mechanism capable of diagnosing the degree of deterioration of a contactor among circuit components constituting a battery pack, and predicting and managing a lifespan of the contactor according to the diagnosis result. To this end, the present disclosure provides a configuration of calculating a state of health (SOH) of a contactor based on one or more of the number of times of operation for each power condition, the number of times of operation for each temperature change, and an operating time of the contactor, and identifying the remaining lifespan according to the calculated SOH.

FIG. 1

**Description**

**FIELD**

The present disclosure relates to a device and method for diagnosing the deterioration of a contactor, and a battery management system.

**BACKGROUND**

The European Union (EU) Battery Regulation, which came into effect on February 18, 2024, requires that battery packs for industrial, light means of transport (LMT), and electric vehicle (xEV) use should be reusable and recyclable, and should allow end users to easily remove and replace components of a battery pack, such as individual battery cells. The EU Battery Regulation also requires that software applied to the battery pack should not hinder the replacement of key components, but there is no separate guidance on the lifespan of a circuit configuration related to a battery management system (BMS) which calculates a protection operation and a state-of-x (SOX) of the battery pack when the components are replaced.

The above information disclosed in this background section is for enhancement of understanding of the background of the present disclosure, and therefore, it may contain information that does not constitute related (or prior) art.

**SUMMARY**

The present disclosure is directed to providing a contactor diagnosis device and method capable of diagnosing the degree of deterioration of a contactor applied to a battery management system (BMS) among the circuit components constituting a battery pack, and predicting and managing the lifespan of the contactor according to the diagnosis result, and the battery management system.

However, objects that the present technology intends to achieve are not limited to the above-described objects, and other objects that are not described may be clearly understood by those skilled in the art from the following description.

A contactor diagnosis device according to some embodiments of the present disclosure for solving the technical problems described herein may include a processor; and a memory that stores at least one command for execution by the processor, wherein the processor is configured to diagnose the deterioration of a contactor based on one or more among the number of times of operation for each power condition, the number of times of operation for each temperature change, and an operating time of the contactor acquired in a process of controlling the contactor constituting a battery management system (BMS).

In some embodiments, the processor is configured to calculate first to third states of health (SOHs) of the contactor based on the number of times of operation for each power condition, the number of times of operation for each temperature change, and the operating time, and is configured to calculate a final SOH of the contactor based on a magnitude of each of the calculated first to third SOHs.

In some embodiments, first reference information including a plurality of power ranges formed in the contactor when the contactor operates and an allowable number of times of operation mapped to each power range is predefined in the memory; and the processor calculates the first SOH based on an actual number of times of operation of the contactor in each power range and the allowable number of times of operation mapped to each power range.

In some embodiments, the processor is configured to calculate the first SOH by calculating an SOH for each power range based on a ratio of the actual number of times of operation of the contactor in each power range and the allowable number of times of operation.

In some embodiments, the first reference information further includes a first weight mapped to each power range and a first average allowable number of times of operation for a weighted average calculation; and the processor is configured to calculate a weighted SOH by calculating a weighted average using a weighted sum result between the actual number of times of operation of the contactor in each power range and the first weight, and the first average allowable number of times of operation, and is configured to calculate a minimum value among the SOH for each power range and the weighted SOH as the first SOH.

In some embodiments, second reference information including a plurality of temperature change ranges formed in the contactor when the contactor operates, a second weight mapped to each temperature change range, and a second average allowable number of times of operation for a weighted average calculation is predefined in the memory; and the processor is configured to calculate the second SOH by calculating a weighted average using a weighted sum result between an actual number of times of operation of the contactor which caused a temperature change in each temperature change range of the second reference information and the second weight, and the second average allowable number of times of operation.

In some embodiments, third reference information including a plurality of SOH ranges according to a set step is predefined in the memory; and the processor is configured to calculate the third SOH by determining a reference SOH of the contactor corresponding to the operating time of the contactor based on the third reference information, specifying a target SOH range to which the reference SOH belongs among the plurality of SOH ranges, and applying a third weight according to a number of times that the target SOH range is specified to the reference SOH.

In some embodiments, the third weight is differently determined according to a ratio between the number of times that the target SOH range is specified and a reference value mapped to the target SOH range.

In some embodiments, when the ratio between the number of times that the target SOH range is specified and the reference value mapped to the target SOH range is smaller than a set ratio: the third weight is determined by a product of (i) the ratio between the number of times that the target SOH range is specified and the reference value mapped to the target SOH range and (ii) the set step, and the processor subtracts the third weight from the reference SOH to calculate the third SOH.

In some embodiments, when the ratio between the number of times that the target SOH range is specified and the reference value mapped to the target SOH range is greater than or equal to the set ratio: the third weight is determined as a set margin value, and the processor adds the set margin value to a lower limit SOH of the target SOH range to calculate the third SOH.

In some embodiments, the reference SOH is determined to have a lower value when the operating time of the contactor is larger.

In some embodiments, the processor is configured to calculate a minimum value among the first to third SOHs as the final SOH of the contactor.

In some embodiments, the processor is configured to transmit a deterioration diagnosis result of the contactor to an external device only when a currently received diagnosis information transmission request is authenticated by a predefined authentication key.

A contactor diagnosis method according to some embodiments of the present disclosure may include controlling, by a processor, a contactor constituting a battery management system (BMS); acquiring, by the processor, operation information of the contactor in a process of controlling the contactor, wherein the operation information includes one or more of a number of times of operation for each power condition of a plurality of power conditions, a number of times of operation for each temperature change of a plurality of temperature changes, and an operating time of the contactor; and diagnosing, by the processor, a deterioration of the contactor based on the operation information of the contactor.

In some embodiments, in the diagnosing, the processor calculates first to third states of health (SOHs) of the contactor based on the number of times of operation for each power condition, the number of times of operation for each temperature change, and the operating time, and calculates a final SOH of the contactor based on a magnitude of each of the calculated first to third SOHs.

In some embodiments, first reference information including a plurality of power ranges formed in the contactor when the contactor operates, an allowable number of times of operation mapped to each power range, a first weight mapped to each power range, and an average allowable number of times of operation for a weighted average calculation is predefined; and in the diagnosing, the processor calculates an SOH for each power range based on an actual number of times of operation of the contactor in each power range and the allowable number of times of operation mapped to each power range, calculates a weighted SOH by calculating a weighted average using a weighted sum result between the actual number of times of operation of the contactor in each power range and the first weight, and the average allowable number of times of operation, and calculates a minimum value among the SOH for each power range and the weighted SOH as the first SOH.

In some embodiments, second reference information including a plurality of temperature change ranges formed in the contactor when the contactor operates, a second weight mapped to each temperature change range, and a second average allowable number of times of operation for a weighted average calculation is predefined; and in the diagnosing, the processor calculates the second SOH by calculating a weighted average using a weighted sum result between an actual number of times of operation of the contactor which caused a temperature change in each temperature change range of the second reference information and the second weight, and the second average allowable number of times of operation.

In some embodiments, third reference information including a plurality of SOH ranges according to a set step is predefined; and in the diagnosing, the processor determines a reference SOH of the contactor corresponding to the operating time of the contactor based on the third reference information, specifies a target SOH range to which the reference SOH belongs among the plurality of SOH ranges, and calculates the third SOH by applying a third weight according to the number of times that the target SOH range is specified to the reference SOH.

In some embodiments, in the diagnosing, the processor calculates a minimum value among the first to third SOHs as the final SOH of the contactor.

A battery management system (BMS) according to some embodiments of the present disclosure may include a micro controller unit (MCU); a memory that stores at least one command for execution by the MCU; and a contactor constituting the BMS, wherein the MCU diagnoses a deterioration of the contactor based on one or more of a number of times of operation for each power condition, a number of times of operation for each temperature change, and an operating time of the contactor acquired in a process of controlling the contactor.

At least some of the above and other features of the invention are set out in the claims.

## BRIEF DESCRIPTION OF THE DRAWINGS

The following drawings accompanying this specification illustrate embodiments of the present disclosure, and further describe aspects and features of the present disclosure together with the detailed description of the present disclosure. Thus, the present disclosure should not be construed as being limited to the drawings, in which:

FIG. 1 illustrates an example of a battery management system (BMS) circuit structure to which a contactor diagnosis device, according to some embodiments of the present disclosure, is applied;

FIG. 2 illustrates a block diagram of the contactor diagnosis device, according to some embodiments of the present disclosure;

FIGS. 3 and 4 illustrate examples of a process of acquiring operation information of a contactor in the contactor diagnosis device, according to some embodiments of the present disclosure; and

FIGS. 5 and 6 illustrate flowcharts of a contactor diagnosis method, according to some embodiments of the present disclosure.

## DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meanings and concepts consistent with the technical idea of the present disclosure based on the principle that the inventor can be his/her own lexicographer to appropriately define the concept of the term to explain the present technology in the most suitable way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the drawings, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, the applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on or "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

As discussed herein, the EU Battery Regulation requires that software applied to a battery pack should not hinder the replacement of key components; however, there is no separate guidance on the lifespan of a circuit configuration related to a battery management system (BMS) which calculates a protection operation and a state-of-x (SOX) of the battery pack when the components are replaced.

There is a large deviation in a deterioration state of the components according to the usage environment and history, and thus the BMS mounted in the battery pack has a problem that it is difficult to predict the remaining lifespan. The lifespan of the components is sufficiently long compared to a designed lifespan of the finished battery pack, so lifespan management of the components has not been considered during design until now, but when the battery cells, which are major components, are replaced for reuse and recycling of the battery pack, since the lifespan of the battery pack is also rapidly increasing, the need to predict and manage the remaining lifespan of a circuit component such as the BMS, which is an unreplaced component, in the battery pack is emerging.

However, currently, the lifespan of a circuit component of the battery pack, such as the BMS, is managed on a 'paper basis,' such as the date of manufacture, and there is no quantitative lifespan management method.

1. BMS circuit structure

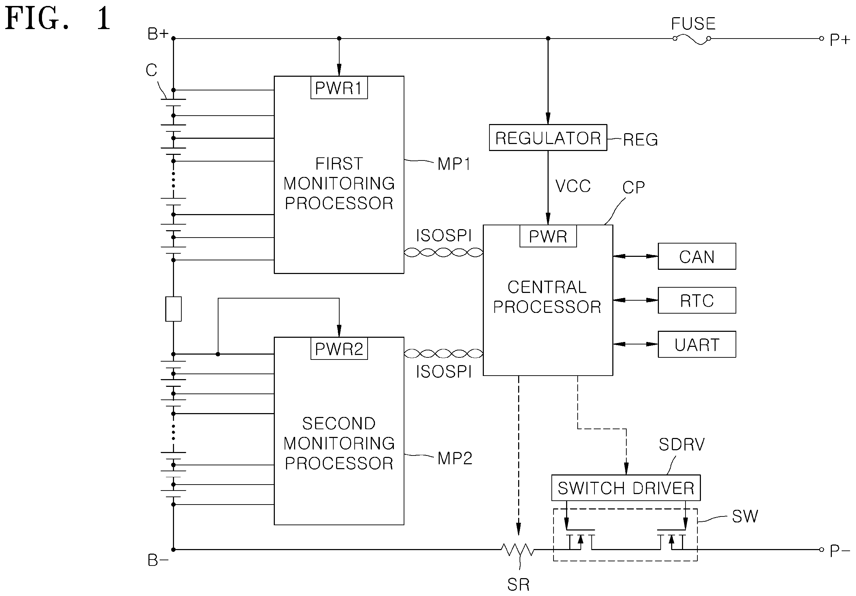

FIG. 1 illustrates an example of a battery management system (BMS) circuit structure to which a contactor diagnosis device, according to some embodiments of the present disclosure, is applied. In order to help understand the example embodiments, the BMS circuit structure, to which the embodiments are applied, will be described first with reference to FIG. 1.

Referring to FIG. 1, the battery management system (hereinafter, BMS) of the example embodiments may include first and second monitoring processors MP1 and MP2, a central processor CP, a shunt resistor SR, a charge/-discharge switch SW, a switch driver SDRV, a regulator REG, and a fuse FUSE. The BMS may be configured to be electrically connected to a plurality of battery cells C interconnected in series.

The first and second monitoring processors MP1 and MP2 may correspond to analog front ends (AFEs) which monitor a state of each battery cell C and perform a battery cell control operation according to a monitoring result. For example, each monitoring processor MP1 and MP2 may be configured to monitor a voltage, a current, a temperature, and a state of charge (SOC) of the battery cell C, and perform control operations such as balancing control, temperature control, and charge/discharge control of the battery cell C or perform a protection operation such as control of the charge/discharge switch SW for preventing overdischarge or overcharging according to the monitoring result. The state data of the battery cell C acquired by each monitoring processor MP1 and MP2 (that is, the voltage, current, temperature, and/or SOC of the battery cell C) may be transmitted to the central processor CP to be described below through isolated serial peripheral interface (isoSPI) communication. Meanwhile, in an example in which battery cells C having a 32S (i.e. 32 battery cells) structure are provided, the first monitoring processor MP1 may correspond to an upper AFE which monitors a state of 16 battery cells C at an upper end and performs balancing according to the state, and the second monitoring processor MP2 may correspond to a lower AFE which monitors a state of 16 battery cells C at a lower end and performs balancing according to the state. The first and second monitoring processors MP1 and MP2 may receive their operating voltage from the plurality of battery cells C through the terminals PWR1 and PWR2, respectively, as shown in FIG. 1.

The central processor CP may allow the first and second monitoring processors MP1 and MP2 to perform the above-described control operation and protection operation by generating a control operation command or protection operation command according to the state data of the battery cell C transmitted from the first and second monitoring processors MP1 and MP2 and feeding the state data back to the first and second monitoring processors MP1 and MP2. The central processor CP which performs this function may correspond to a micro controller unit (MCU) of the BMS. The central processor CP may communicate with an upper controller (for example, a vehicle electronic control unit (ECU)) through a communication protocol such as a controller area network (CAN), real time clock (RTC), or universal asynchronous receiver/transmitter (UART).

The shunt resistor SR is connected on a path (corresponding to a charge/discharge path) from a positive terminal of a battery pack to a negative terminal of the battery pack through the battery cell C, and may function as a resistance element for detecting an overcurrent flowing in the battery cell C.

The charge/discharge switch SW may correspond to a metal oxide semiconductor field-effect transistor (MOSFET) which controls a current flow on the above-described charge/discharge path, and the switch driver SDRV may correspond to a gate driver which controls the on/off operation of the charge/discharge switch SW under the control of the central processor CP. For example, the shunt resistor SR may be connected between a lowermost node B- of the plurality of battery cells C and the charging/discharging switch SW.

The entity which performs an operation of detecting the overcurrent through the shunt resistor SR and an operation of controlling the on/off operation of the charge/discharge switch SW by controlling the switch driver SDRV when the overcurrent is detected may correspond to the first and second monitoring processors MP1 and MP2 or may correspond to the central processor CP. FIG. 1 illustrates an example in which the entity which performs the above operations corresponds to the central processor CP, and in this case, the central processor CP may operate to prevent damage to the battery cell C due to the overcurrent by detecting a state in which the overcurrent flows to the battery cell C through the shunt resistor SR and controlling the switch driver SDRV to turn off the charge/discharge switch SW.

The regulator REG may regulate a voltage level at an uppermost node B+ of the plurality of battery cells C to a level corresponding to an operating voltage of the central processor CP, and an operating voltage VCC of the central processor CP may be generated by the regulator REG. The central processor CP may receive the operating voltage VCC through terminal PWR. The regulator REG may be implemented as a direct-current (DC)/DC converter which converts a voltage at the uppermost node B+ of the plurality of battery cells C into the operating voltage of the central processor CP.

The fuse FUSE may be configured to interrupt a current path connected to the plurality of battery cells C (i.e., the aforementioned charging/discharging path). Interrupting the current path may mean interrupting the flow of current through physical cutting of the current path. For example, the fuse FUSE may be implemented as a pyrofuse.

Based on the circuit structure of the above BMS, the example embodiments focus on a configuration of diagnosing the deterioration of the contactor. The contactor to be diagnosed in the example embodiments may correspond to, for example, the charge/discharge switch SW for controlling the charge/discharge of the battery cell C shown in FIG. 1. However, the contactor is not limited to the charge/discharge switch SW, and a switch element (for example, a balancing switch or a relay which controls an electrical connection between a battery terminal and a load) which constitutes the BMS and performs the on/off operation may correspond to the contactor of the example embodiments.

2. Contactor diagnosis device

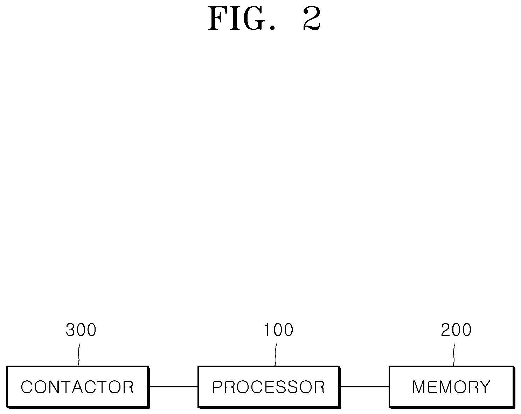

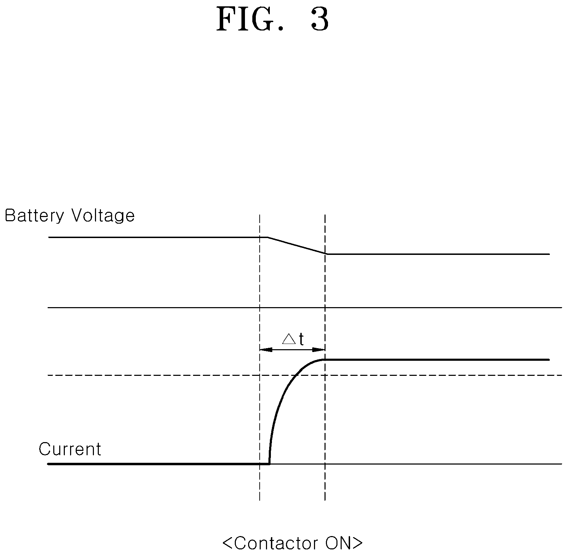

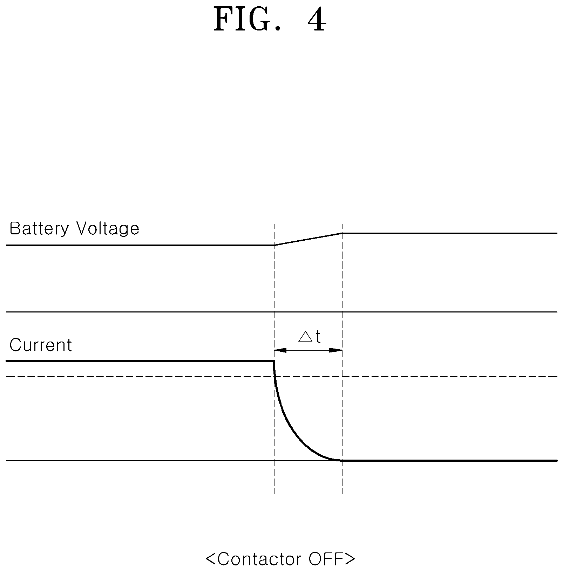

FIG. 2 is a block diagram of the contactor diagnosis device according to some embodiments of the present disclosure. FIG. 3 is an example diagram for describing a process of acquiring operation information of the contactor in the contactor diagnosis device according to some embodiments of the present disclosure. FIG. 4 is another example diagram for describing a process of acquiring operation information of the contactor in the contactor diagnosis device according to some embodiments of the present disclosure.

Referring to FIG. 2, the contactor diagnosis device of the example embodiments may include a processor 100 and a memory 200, and each component (the processor 100 and memory 200) may constitute the BMS along with a contactor 300 which is a deterioration diagnosis target.

The processor 100 may be the entity which diagnoses the deterioration of the contactor 300, may be implemented as a central processing unit (CPU) or system on chip (SoC), may control a plurality of hardware or software components connected to the processor 100 by driving an operating system or application, and may perform various types of data processing and calculations. The processor 100 may be configured to execute at least one command stored in the memory 200 to be described below, and store the execution result data in the memory 200. Specifically, in the example embodiments, the processor 100 may be implemented as a micro controller unit (MCU) (corresponding to the same configuration as the central processor CP in FIG. 1) in the BMS.

At least one command executed by the processor 100 may be stored in the memory 200. The memory 200 may be implemented as a volatile storage medium and/or a non-volatile storage medium, may be implemented as non-transitory, and may be implemented as, for example, a read only memory (ROM), a random access memory (RAM), a flash memory, or an electrically erasable programmable read-only memory (EEPROM). The memory may be configured to store at least one command for execution by the processor.

First to third types of reference information may be predefined in the memory 200. As will be described below, the first to third types of reference information may be respectively utilized in processes of calculating first to third states of health (SOHs). Table 1 below shows each type of reference information stored in the memory 200 classified by its use. Specific examples in which the first to third types of reference information of Table 1 and other information are utilized will be described below.

TABLE 1

| Reference information | Details | Use |
|---|---|---|
| First reference information | plurality of power ranges | calculate first SOH |
| | allowable number of times of operation mapped to each power range | |
| | first weight mapped to each power range | |
| | first average allowable number of times of operation | |
| Second reference information | plurality of temperature change ranges | calculate second SOH |
| | second weight mapped to each temperature change range | |
| | second average allowable number of times of operation | |
| Third reference information | relationship information between operating time and reference SOH | calculate third SOH |
| | plurality of SOH ranges according to set step | |
| | reference value mapped to each SOH range | |
| | set ratio | |
| Other information | threshold SOH, threshold value | warning to not use |
| | relationship information between SOH and remaining lifespan | determine remaining lifespan |

Based on the above-described content, a configuration of diagnosing the deterioration of the contactor 300 will be specifically described below focusing on the operation of the processor 100.

The processor 100 may control the operation of the contactor 300 according to the BMS control logic predefined in the memory 200. In an example in which the contactor 300 is the charge/discharge switch SW, the processor 100 may control the on/off operation of the charge/discharge switch SW according to typical BMS control logic by turning off the charge/discharge switch SW when the overcurrent is detected through the shunt resistor SR and turning on the charge/discharge switch SW when the overcurrent state is resolved.

In the process of controlling the contactor 300, the processor 100 may be configured to acquire operation information of the contactor 300, and the operation information may include one or more among the number of times of operation for each power condition, the number of times of operation for each temperature change, and the operating time of the contactor 300. The 'operation' of the contactor 300 may be an on operation or an off operation of the contactor 300.

Regarding a method of acquiring the number of times of operation of the contactor 300, as shown in FIGS. 3 and 4, a method of detecting a current flowing in the shunt resistor SR connected to the charge/discharge switch SW in series or a voltage of the battery cell may be adopted. For example, the number of on operations of the contactor 300 may be acquired by counting a rising section of the current flowing in the shunt resistor SR as shown in FIG. 3 when the contactor 300 operates, and the number of off operations of the contactor 300 may be acquired by counting a falling section of the current flowing in the shunt resistor SR as shown in FIG. 4 when the contactor 300 does not operate. As another example, the number of on operations of the contactor 300 may be acquired by counting a falling section of the battery cell voltage as shown in FIG. 3 when the contactor 300 operates, and the number of off operations of the contactor 300 may be acquired by counting a rising section of the battery cell voltage as shown in FIG. 4 when the contactor 300 does not operate (a serial connection structure of the battery cell C, the shunt resistor SR, and the contactor 300 (the charge/discharge switch SW) shown in FIG. 1 is assumed in this non-limiting example). The operating time of the contactor 300 (that is, the time required for the contactor 300 to be switched from the off state to the on state, or the time required for the contactor 300 to be switched from the on state to the off state) corresponds to a time length ($\Delta t$) of the current rising section or the voltage falling section in FIG. 3, or a time length ($\Delta t$) of the current falling section or the voltage rising section in FIG. 4.

The processor 100 may calculate the first to third states of health (SOHs) of the contactor 300 based on the number of times of operation for each power condition, the number of times of operation for each temperature change, and the operating time, respectively, and may calculate a final SOH of the contactor 300 based on the magnitude of each of the calculated first to third SOHs.

In the description of a process of calculating the first SOH, the first SOH is related to the above-described number of times of operation for each power condition, and the processor 100 may calculate the first SOH using first reference information stored in the memory 200. Here, the first reference information may include a plurality of power ranges formed in the contactor 300 when the contactor 300 operates (that is, when the contactor 300 is turned on or off by the processor 100), the allowable number of times of operation mapped to each power range, a first weight mapped to each power range, and the first average allowable number of times of operation for a weighted average calculation. Table 2 below shows an example of the first reference information.

TABLE 2

| Power range | Allowable number of times of operation | First weight | First average allowable number of times of operation |
|---|---|---|---|
| smaller than or equal to 1 W | - | - | 80 |
| greater than 1 W and smaller than or equal to 1.2 W | 100 | 0.2 | |
| greater than 1.2 W and smaller than or equal to 1.4 W | 80 | 0.3 | |
| greater than 1.4 W and smaller than 1.6 W | 60 | 0.5 | |

The plurality of power ranges of the first reference information may be predefined in consideration of the power which may be formed in the contactor 300 in a range greater than or equal to the rated power of the contactor 300. For example, when the rated power of the contactor 300 is 1 W, the plurality of power ranges may include ranges smaller than or equal to 1 W, greater than 1 W and smaller than or equal to 1.2 W, greater than 1.2 W and smaller than or equal to 1.4 W, and greater than 1.4 W and smaller than 1.6 W as shown in Table 2. The steps (0.2 W in the above example) of the plurality of power ranges and the number of power ranges may be predesigned based on the specifications of the contactor 300 and the experimental results of the designer. Meanwhile, since the contactor 300 corresponds to a case in which the contactor 300 normally operates when operating in a range smaller than or equal to the rated power, the number of times may not be counted in a deterioration diagnosis process.

Further, the allowable number of times of operation mapped to each power range may be the maximum number of times of operation that the contactor 300 may operate in each power range. The first weight mapped to each power range may be a parameter applied to the actual number of times of operation of the contactor 300 in each power range in the process of calculating a weighted SOH to be described below, and considering that the larger the value of the power range (that is, the larger the value of the median of the power range), the greater the degree of deterioration of the contactor 300, the first weight mapped to the corresponding power range may be predefined to have a larger value as the power range has a larger value. The first average allowable number of times of operation may be a parameter applied to a weighted sum result between the actual number of times of operation of the contactor 300 and the first weight to calculate the weighted average in the process of calculating the weighted SOH to be described below, and may have an average value of the allowable number of times of operation (100, 80, and 60 in Table 2) included in the first reference information.

As described above, when the first reference information is defined in the memory 200, the processor 100 may calculate the SOH for each power range based on the actual number of times of operation of the contactor 300 in each power range and the allowable number of times of operation mapped to each power range. Here, the actual number of times of operation of the contactor 300 in each power range may be identified by calculating the product (that is, a power value) of the voltage and current applied to the contactor 300 when the contactor 300 actually operates. The SOH for each power range may be calculated according to the following Equation 1.

(Equation 1)

$$SOH_{power}(i) = 1 - \frac{N_{actual}(i)}{N_{allowed}(i)}$$

In Equation 1, $SOH_{power}(i)$ is an SOH in an ith power range, $N_{actual}(i)$ is the number of times that the contactor 300 actually operates in the ith power range, and $N_{allowed}(i)$ is the allowable number of times of operation mapped to the ith power range. In the example of Table 2, a total of three SOHs for each power range may be calculated for each power range of greater than 1 W and smaller than or equal to 1.2 W, greater than 1.2 W and smaller than or equal to 1.4 W, and greater than 1.4 W and smaller than 1.6 W.

Further, the processor 100 may calculate the weighted SOH by calculating a weighted average using the weighted sum result between the actual number of times of operation of the contactor 300 in each power range and the first weight, and the first average allowable number of times of operation. The weighted SOH may be calculated according to the following Equation 2.

(Equation 2)

$$SOH_{weighted} = 1 - \frac{\sum_{i=1}^{k} N_{actual}(i) \times W(i)}{N_{allowed\_avg}1}$$

In Equation 2, $SOH_{weighted}$ is the weighted SOH, $N_{actual}(i)$ is the number of times that the contactor 300 actually operates in the ith power range, $W(i)$ is the first weight mapped to the ith power range, $N_{allowed\_avg}1$ is the first average allowable number of times of operation, and k is the number of power ranges excluding the range smaller than or equal to rated power (k = 3 in Table 2).

When the SOH for each power range and the weighted SOH are calculated, the processor 100 may calculate a minimum value among the SOH for each power range and the weighted SOH as the first SOH.

In order to describe a specific example, it is assumed that the actual number of times of operation of the contactor 300 in each power range is measured as shown in Table 3 below.

TABLE 3

| Power range | Actual number of times of operation | Allowable number of times of operation | First weight | First average allowable number of times of operation |
|---|---|---|---|---|
| smaller than or equal to 1 W | - | - | - | 80 |
| greater than 1 W and smaller than or equal to 1.2 W | **20** | 100 | 0.2 | |
| greater than 1.2 W and smaller than or equal to 1.4 W | **10** | 80 | 0.3 | |
| greater than 1.4 W and smaller than 1.6 W | **15** | 60 | 0.5 | |

According to Equations 1 and 2, the SOH for each power range and the weighted SOH are calculated as shown in Table 4 below.

TABLE 4

| Power range | Actual number of times of operation | Allowable number of times of operation | SOH for each power range | First weight | First average allowable number of times of operation | Weighted SOH |
|---|---|---|---|---|---|---|
| smaller than or equal to 1 W | - | - | - | - | 80 | **81.88%** |
| greater than 1 W and smaller than or equal to 1.2 W | 20 | 100 | **80%** | 0.2 | | |
| greater than 1.2 W and smaller than or equal to 1.4 W | 10 | 80 | **87.5%** | 0.3 | | |
| greater than 1.4 W and smaller than 1.6 W | 15 | 60 | **75%** | 0.5 | | |

Accordingly, the minimum value of 75%, among 80%, 87.5%, and 75% corresponding to SOHs for each power range and 81.88% corresponding to the weighted SOH, is determined as the first SOH.

The SOH for each power range is an SOH calculated based on the number of times that the contactor 300 operates in each power range, and the weighted SOH corresponds to an SOH calculated by integrating all power ranges and applying the weight for each power range, and as the minimum value among the SOHs calculated through these various SOH calculation processes is determined as the first SOH, a more reliable SOH may be determined.

Next, in the description of a process for calculating the second SOH, the second SOH relates to the number of times of operation for each temperature change, and the processor 100 may calculate the second SOH using second reference information stored in the memory 200. Here, the second reference information may include a plurality of temperature change ranges formed in the contactor 300 when the contactor 300 operates, a second weight mapped to each temperature change range, and a second average allowable number of times of operation for a weighted average calculation (the term 'average' of the second average allowable number of times of operation is used to indicate that it is a parameter applied to calculate the weighted average, and it is to be noted that the second average allowable number of times of operation does not correspond to an average of any values). Table 5 below shows an example of the second reference information.

TABLE 5

| Temperature change range | Second weight | Second average allowable number of times of operation |
|---|---|---|
| greater than or equal to 5 °C and smaller than 10 °C | 0.15 | |
| greater than or equal to 10 °C and smaller than 15 °C | 0.20 | 35 |
| greater than or equal to 15 °C and smaller than 20 °C | 0.30 | |
| greater than or equal to 20 °C | 0.35 | |

The plurality of temperature change ranges of the second reference information may be predefined in consideration of a temperature change value which causes deterioration of the contactor 300, and the steps (5 °C in the above example) of the plurality of temperature change ranges and the number of temperature change ranges may be predesigned based on the specifications of the contactor 300 and the experimental results of the designer. Meanwhile, the operation of calculating the second SOH using the second reference information may be performed only when the temperature of the contactor 300 is greater than or equal to a threshold temperature (for example, 100 °C).

The second weight mapped to each temperature change range is a parameter applied to the actual number of times of operation of the contactor 300 in each temperature change range in the process of calculating the second SOH, and considering that the larger the value of the temperature change range (that is, the larger the value of the median of the temperature change range), the greater the degree of deterioration of the contactor 300, the second weight mapped to the corresponding temperature change range may be predefined to have a larger value as the temperature change range has a larger value. The second average allowable number of times of operation is a parameter applied to a weighted sum result between the actual number of times of operation of the contactor 300 and the second weight to calculate the weighted average in the process of calculating the second SOH, and this value may be predefined based on the experimental results of the designer.

As described above, when the second reference information is defined in the memory 200, the processor 100 may calculate the second SOH by calculating the weighted average using a weighted sum result between the actual number of times of operation of the contactor 300 which caused a temperature change in each temperature change range of the second reference information and the second weight, and the second average allowable number of times of operation. The second SOH may be calculated according to the following Equation 3.

(Equation 3)

$$SOH_2 = 1 - \frac{\sum_{i=1}^{k} N_{actual}(i) \times W(i)}{N_{allowed\_avg2}}$$

In Equation 3, $SOH_2$ is the second SOH, $N_{actual}(i)$ is the number of times that the contactor 300 actually operates in an ith temperature change range, $W(i)$ is the second weight mapped to the ith temperature change range, $N_{allowed\_avg2}$ is the second average allowable number of times of operation, and k is the number of temperature change ranges ($k = 4$ in Table 5).

Table 6 shows an example in which the second SOH is calculated to be 79.71% through Equation 3 when the actual number of times of operation of the contactor 300 was measured to be 10, 5, 6, or 8 in each temperature change range.

TABLE 6

| Temperature change range | Actual number of times of operation | Second weight | Second average allowable number of times of operation | Second SOH |
|---|---|---|---|---|
| greater than or equal to 5 °C and smaller than 10 °C | **10** | 0.15 | | |
| greater than or equal to 10 °C and smaller than 15 °C | **5** | 0.20 | 35 | **79.71 %** |
| greater than or equal to 15 °C and smaller than 20 °C | **6** | 0.30 | | |
| greater than or equal to 20 °C | **8** | 0.35 | | |

Next, in the description of a process for calculating the third SOH, the third SOH relates to the operating time of the contactor 300, and the processor 100 may calculate the third SOH using third reference information stored in the memory 200. Here, the third reference information may include a plurality of SOH ranges according to the set step.

Specifically, the processor 100 may determine a reference SOH of the contactor 300 corresponding to the operating time of the contactor 300 based on the third reference information, specify a target SOH range to which the reference SOH belongs among the plurality of SOH ranges of the third reference information, and calculate the third SOH by applying a third weight according to the number of times that the target SOH range is specified to the reference SOH. The reference SOH may be determined from the 'relationship information between the operating time and the reference SOH' in the above-described Table 1, and may correspond to an SOH primarily determined based only on the operating time of the contactor 300. That is, the processor 100 may calculate the third SOH by primarily determining the reference SOH using the operating time first, and then correcting the determined reference SOH using the third weight to be described below. The relationship information between the operating time and the reference SOH may be predefined in such a way that the longer the operating time, the lower the reference SOH is determined. That is, since the degree of deterioration of the contactor 300 is higher as the operating time is longer, the operating time and the reference SOH may be set to have an inversely proportional relationship, and a specific numerical value may be set to a specific value based on the specifications of the contactor 300 and the experimental results of the designer.

In order to determine the third weight for correcting the reference SOH, the processor 100 may specify the target SOH range to which the reference SOH belongs among the plurality of SOH ranges. Table 7 below shows examples of the plurality of SOH ranges and the reference value mapped to each SOH. Table 7 shows an example in which the set step of each SOH range is 20%.

TABLE 7

| SOH range | Reference value |
|---|---|
| greater than or equal to 0% and smaller than 20% | 600 |
| greater than or equal to 20% and smaller than 40% | 800 |
| greater than or equal to 40% and smaller than 60% | 1000 |
| greater than or equal to 60% and smaller than or equal to 100% | - |

As a specific example, when the reference SOH is determined to be 55%, the target SOH range to which the reference SOH belongs is determined to be a range greater than or equal to 40% and smaller than 60%, and the reference value is determined to be 1000. Meanwhile, considering that the SOH range greater than or equal to 60% and smaller than or equal to 100% is a state in which the deterioration of the contactor 300 has not progressed to the extent of determining its remaining lifespan, a calculation operation of the third SOH may be omitted when the reference SOH has a value greater than or equal to 60% and smaller than or equal to 100%. The third weight may be determined based on the number of times that the target SOH range is specified, and specifically, may be differentially determined according to a ratio between the number of times that the target SOH range is specified and the reference value mapped to the target SOH range.

When the ratio between the number of times that the target SOH range is specified and the reference value mapped to the target SOH range is smaller than the set ratio (the set ratio may have a value of 1), the third weight may be determined by the product of (i) the ratio between the number of times that the target SOH range is specified and the reference value mapped to the target SOH range and (ii) the set step.

In the above-described example, when the number of times that the target SOH range is specified as a range greater than or equal to 40% and smaller than 60% is 100, the ratio between the number of times that the target SOH range is specified (100) and the reference value (1000) is 0.1, and since the calculated ratio of 0.1 is a value smaller than the set ratio of 1, the third weight is determined to be 2 which is the product of the calculated ratio of 0.1 and the set step of 20.

When the third weight is determined, the processor 100 may calculate the third SOH by subtracting the third weight from the reference SOH. In the above-described example, the third SOH is calculated to be a value of 53% in which the third weight of 2 is subtracted from the reference SOH of 55. According to this calculation method, as the number of times that the target SOH range is specified increases in a range smaller than or equal to the reference value (that is, as the number of times of operation in the target SOH range is large), the third weight increases, and accordingly, the third SOH is calculated as a smaller value.

Meanwhile, when the ratio between the number of times that the target SOH range is specified and the reference value is greater than or equal to the set ratio, the third weight may be determined as a set margin value (for example, 1). The set margin value may correspond to a value predesigned to correct a lower limit SOH to be described below of the target SOH range.

In the above example, when the number of times that the target SOH range is specified as a range greater than or equal to 40% and smaller than 60% is 1100, the ratio between the number of times that the target SOH range is specified (1100) and the reference value (1000) is 1.1, and since the calculated ratio of 1.1 is a value greater than or equal to the set ratio of 1, the third weight is determined as a set margin value of 1.

When the third weight is determined, the processor 100 may calculate the third SOH by adding the third weight to the lower limit SOH of the target SOH range. In the above-described example, the third SOH is calculated to be a value of 41% in which the set margin value of 1 is added to the lower limit SOH of 40 of the target SOH range. That is, when the number of times that the target SOH range is specified is greater than or equal to the reference value (when the number of times of operation in the target SOH range is greater than or equal to the reference value), it can be seen that the deterioration of the contactor 300 has significantly progressed, and in consideration of the progressed deterioration of this contactor 300, as the third SOH is calculated by setting the SOH to be corrected as the lower limit SOH of the target SOH range instead of the reference SOH and then adding the predefined set margin value to the set lower limit SOH, a topology may be provided in which a third SOH always having a value smaller than or equal to a case in which the ratio between the number of times that the target SOH range is specified and the reference value is smaller than the set ratio is determined.

A formula in which the third SOH is calculated is as shown in Equation 4 below.

(Equation 4)

$$SOH_3 = SOH_{ref} - step \times \frac{N_{target}}{N_{ref}} \quad when \quad \frac{N_{target}}{N_{ref}} < 1$$

$$SOH_3 = SOH_{lowlimit} + M \quad when \quad \frac{N_{target}}{N_{ref}} \geq 1$$

In Equation 4, $SOH_3$ is the third SOH, $SOH_{ref}$ is the reference SOH, step is the set step, $N_{target}$ is the number of times that the target SOH range is specified, $N_{ref}$ is the reference value, $SOH_{lowlimit}$ is the lower limit SOH of the target SOH range, and M is the set margin value.

When the first to third SOHs are calculated, the processor 100 may calculate the final SOH of the contactor 300 based on the magnitude of each of the first to third SOHs. In this case, in consideration of the worst case for the deterioration of the contactor 300, the processor 100 may calculate the minimum value among the first to third SOHs as the final SOH of the contactor 300.

In addition, when the final SOH calculated as above is smaller than or equal to a predefined threshold SOH or when the number of times of operation and the operating time of the contactor 300 are greater than or equal to respectively predefined threshold values, the processor 100 may stop the on/off control operation for the contactor 300 and may be configured to provide a warning to not use the contactor 300 to the user through a user interface (not shown).

Meanwhile, when the final SOH of the contactor 300 is calculated, the processor 100 may determine the remaining lifespan of the contactor 300 corresponding to the final SOH. In this case, a method of extracting the remaining lifespan corresponding to the final SOH from relationship information between the predefined SOH and the remaining lifespan may be applied. The relationship information between the SOH and the remaining lifespan may be predefined in the memory 200 based on the specifications of the contactor 300 and the experimental results of the designer.

Further, the processor 100 may record the final SOH and the remaining lifespan in the memory 200, and may also be configured to transmit a deterioration diagnosis result (that is, the final SOH and the remaining lifespan) stored in the memory 200 to the outside (e.g., an external device) in response to a diagnosis information transmission request of the contactor 300 received from the outside. In this case, some embodiments may be provided in which the diagnosis information transmission request including an authentication key is transmitted from a separately provided external device to the processor 100, and the final SOH and the remaining lifespan are read from the memory 200 and transmitted to the external device by the processor 100 only when an authentication key prestored/predefined in the memory 200 matches the authentication key of the currently received diagnosis information transmission request (e.g., only when a currently received diagnosis information transmission request is authenticated by a predefined authentication key).

3. Contactor diagnosis method

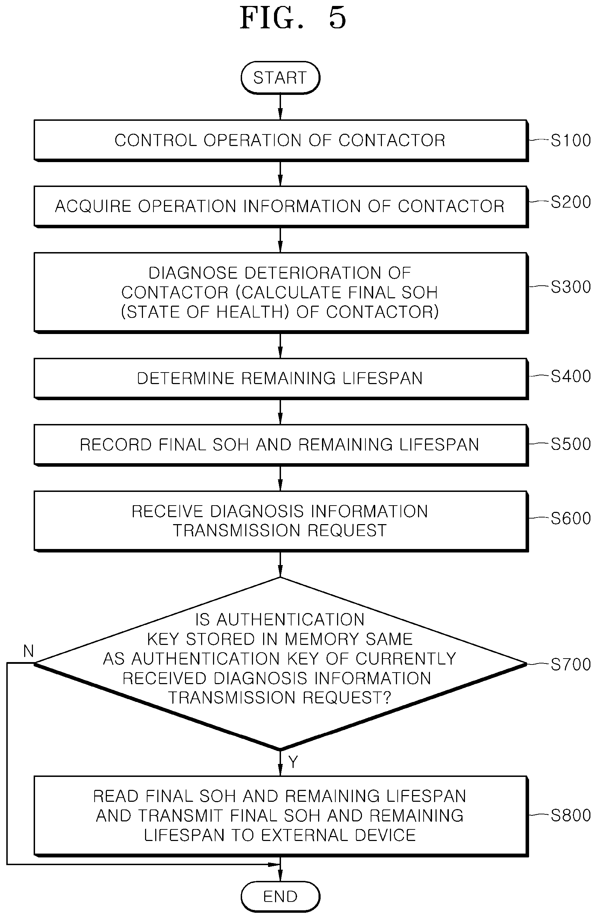

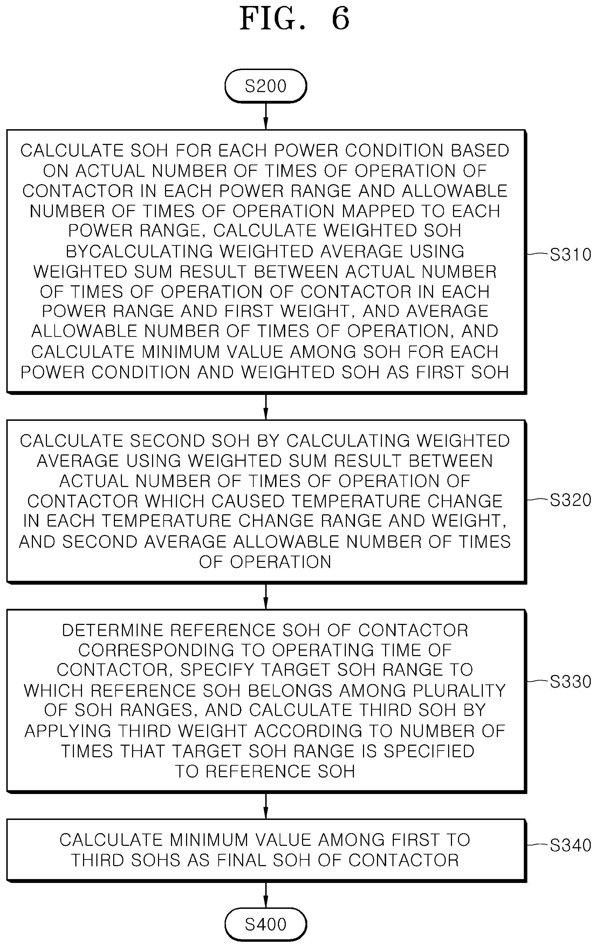

FIG. 5 is a flowchart of a contactor diagnosis method according to some embodiments of the present disclosure. FIG. 6 is a flowchart of a contactor diagnosis method according to some embodiments of the present disclosure. Referring to FIGS. 5 and 6, the contactor diagnosis method according to the example embodiments will be described, specific description of configurations overlapping the above-described content will be omitted, and the description will focus on a time-series configuration.

First, a processor 100 may control the operation of a contactor 300 according to BMS control logic predefined in a memory 200 (operation S 100), and may acquire operation information of the contactor 300 in a process of controlling the contactor 300 (operation S200). The operation information of the contactor 300 may include at least one of the number of times of operation for each power condition (of the plurality of power conditions) of the contactor 300, the number of times of operation for each temperature change (of the plurality of temperature changes), and an operating time.

Subsequently, after operation S200, the processor 100 may diagnose the deterioration of the contactor 300 based on the operation information of the contactor 300 (operation S300).

Referring to FIG. 6, when the operation in operation S300 is performed as described with reference to FIG. 6, the processor 100 may calculate an SOH for each power condition based on the actual number of times of operation of the contactor 300 in each power range, and the allowable number of times of operation mapped to each power range of first reference information, may calculate a weighted SOH by calculating a weighted average using a weighted sum result between the actual number of times of operation of the contactor 300 in each power range and the first weight, and the average allowable number of times of operation, and may calculate a minimum value among the SOH for each power condition and the weighted SOH as a first SOH (operation S310).

Further, the processor 100 may calculate a second SOH by calculating the weighted average using a weighted sum result between the actual number of times of operation of the contactor 300 which caused a temperature change in each temperature change range of second reference information and a weight, and the second average allowable number of times of operation (operation S320).

In addition, the processor 100 may determine a reference SOH of the contactor 300 corresponding to the operating time of the contactor 300 based on third reference information, may specify a target SOH range to which the reference SOH belongs among a plurality of SOH ranges, and may calculate a third SOH by applying a third weight according to the number of times that the target SOH range is specified to the reference SOH (operation S330).

Operations S310 to S330 are operations which may be independently executed, and their execution order is not limited to the above-described order.

When the first to third SOHs are calculated through operations S310 to S330, the processor 100 calculates a minimum value among the first to third SOHs as a final SOH of the contactor (operation S340).

When the final SOH is calculated through operation S300, the processor 100 may determine the remaining lifespan of the contactor 300 corresponding to the final SOH using relationship information between a predefined SOH and the remaining lifespan (operation S400).

Subsequently, the processor 100 may record the final SOH and remaining lifespan of the contactor 300 in the memory 200 (operation S500).

Thereafter, referring to FIG. 5, when a diagnosis information transmission request including an authentication key is received from an external device (operation S600), the processor 100 compares the authentication key prestored in the memory 200 with the authentication key of the currently received diagnosis information transmission request (operation S700), and reads the final SOH and remaining lifespan from the memory 200 and transmits the final SOH and remaining lifespan to the external device only when the two authentication keys match (operation S800).

As described above, according to the present disclosure, as a method of calculating a state of health (SOH) of a contactor based on one or more among the number of times of operation for each power condition, the number of times of operation for each temperature change, and an operating time of the contactor, and identifying the remaining lifespan according to the calculated SOH is adopted, a quantitative lifespan management topology for the contactor constituting a battery management system (BMS) can be provided.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

According to the present disclosure, by adopting a method of calculating a state of health (SOH) of a contactor based on one or more among the number of times of operation for each power condition, the number of times of operation for each temperature change, and an operating time of the contactor, and identifying the remaining lifespan according to the calculated SOH, a quantitative lifespan management topology for the contactor constituting a battery management system (BMS) can be provided.

However, effects that can be achieved through the present technology are not limited to the above-described effects and other effects that are not described may be clearly understood by those skilled in the art from the detailed descriptions.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

Embodiments are set out in the following clauses:

1. A contactor diagnosis device comprising:

   a processor; and
   a memory configured to store at least one command for execution by the processor,
   wherein the processor is configured to diagnose a deterioration of a contactor based on one or more of a number of times of operation for each power condition of a plurality of power conditions, a number of times of operation for each temperature change of a plurality of temperature changes, and an operating time of the contactor acquired in a process of controlling the contactor constituting a battery management system (BMS).

2. The contactor diagnosis device of clause 1, wherein the processor is configured to calculate first to third states of health (SOHs) of the contactor based on the number of times of operation for each power condition, the number of times of operation for each temperature change, and the operating time, and is configured to calculate a final SOH of the contactor based on a magnitude of each of the calculated first to third SOHs.

3. The contactor diagnosis device of clause 2, wherein:

   first reference information including a plurality of power ranges formed in the contactor when the contactor operates and an allowable number of times of operation mapped to each power range is predefined in the memory; and
   the processor calculates the first SOH based on an actual number of times of operation of the contactor in each power range and the allowable number of times of operation mapped to each power range.

4. The contactor diagnosis device of clause 3, wherein the processor is configured to calculate the first SOH by calculating an SOH for each power range based on a ratio of the actual number of times of operation of the contactor in each power range and the allowable number of times of operation.

5. The contactor diagnosis device of clause 4, wherein:

   the first reference information further includes a first weight mapped to each power range and a first average allowable number of times of operation for a weighted average calculation; and
   the processor is configured to calculate a weighted SOH by calculating a weighted average using a weighted sum result between the actual number of times of operation of the contactor in each power range and the first weight, and the first average allowable number of times of operation, and is configured to calculate a minimum value among the SOH for each power range and the weighted SOH as the first SOH.

6. The contactor diagnosis device of any of clauses 2 to 5, wherein:

   second reference information including a plurality of temperature change ranges formed in the contactor when the contactor operates, a second weight mapped to each temperature change range, and a second average allowable number of times of operation for a weighted average calculation is predefined in the memory; and the processor is configured to calculate the second SOH by calculating a weighted average using a weighted sum result between an actual number of times of operation of the contactor which caused a temperature change in each temperature change range of the second reference information and the second weight, and the second average allowable number of times of operation.

7. The contactor diagnosis device of any of clauses 2 to 6, wherein:

third reference information including a plurality of SOH ranges according to a set step is predefined in the memory; and

the processor is configured to calculate the third SOH by determining a reference SOH of the contactor corresponding to the operating time of the contactor based on the third reference information, specifying a target SOH range to which the reference SOH belongs among the plurality of SOH ranges, and applying a third weight according to a number of times that the target SOH range is specified to the reference SOH.

8. The contactor diagnosis device of clause 7, wherein the third weight is differently determined according to a ratio between the number of times that the target SOH range is specified and a reference value mapped to the target SOH range.

9. The contactor diagnosis device of clause 8, wherein, when the ratio between the number of times that the target SOH range is specified and the reference value mapped to the target SOH range is smaller than a set ratio:

the third weight is determined by a product of (i) the ratio between the number of times that the target SOH range is specified and the reference value mapped to the target SOH range and (ii) the set step, and

the processor subtracts the third weight from the reference SOH to calculate the third SOH.

10. The contactor diagnosis device of clause 8 or clause 9, wherein, when the ratio between the number of times that the target SOH range is specified and the reference value mapped to the target SOH range is greater than or equal to the set ratio:

the third weight is determined as a set margin value, and

the processor adds the set margin value to a lower limit SOH of the target SOH range to calculate the third SOH.

11. The contactor diagnosis device of any of clauses 7 to 10, wherein the reference SOH is determined to have a lower value when the operating time of the contactor is larger.

12. The contactor diagnosis device of any of clauses 2 to 11, wherein the processor is configured to calculate a minimum value among the first to third SOHs as the final SOH of the contactor.

13. The contactor diagnosis device of any preceding clause, wherein the processor is configured to transmit a deterioration diagnosis result of the contactor to an external device only when a currently received diagnosis information transmission request is authenticated by a predefined authentication key.

14. A contactor diagnosis method comprising:

controlling, by a processor, a contactor constituting a battery management system (BMS);

acquiring, by the processor, operation information of the contactor in a process of controlling the contactor, wherein the operation information includes one or more of a number of times of operation for each power condition of a plurality of power conditions, a number of times of operation for each temperature change of a plurality of temperature changes, and an operating time of the contactor; and

diagnosing, by the processor, a deterioration of the contactor based on the operation information of the contactor.

15. The contactor diagnosis method of clause 14, wherein, in the diagnosing, the processor calculates first to third states of health (SOHs) of the contactor based on the number of times of operation for each power condition, the number of times of operation for each temperature change, and the operating time, and calculates a final SOH of the contactor based on a magnitude of each of the calculated first to third SOHs.

16. The contactor diagnosis method of clause 15, wherein:

first reference information including a plurality of power ranges formed in the contactor when the contactor operates, an allowable number of times of operation mapped to each power range, a first weight mapped to each power range, and an average allowable number of times of operation for a weighted average calculation is predefined; and

in the diagnosing, the processor calculates an SOH for each power range based on an actual number of times of operation of the contactor in each power range and the allowable number of times of operation mapped to each power range, calculates a weighted SOH by calculating a weighted average using a weighted sum result between the actual number of times of operation of the contactor in each power range and the first weight, and the average allowable number of times of operation, and calculates a minimum value among the SOH for each power range and the weighted SOH as the first SOH.

17. The contactor diagnosis method of clause 15 or clause 16, wherein:

second reference information including a plurality of temperature change ranges formed in the contactor when the contactor operates, a second weight mapped to each temperature change range, and a second average allowable number of times of operation for a weighted average calculation is predefined; and

in the diagnosing, the processor calculates the second SOH by calculating a weighted average using a weighted sum result between an actual number of times of operation of the contactor which caused a temperature change in each temperature change range of the second reference information and the second weight, and the second average allowable number of times of operation.

18. The contactor diagnosis method of any of clauses 15 to 17, wherein:

third reference information including a plurality of SOH ranges according to a set step is predefined; and

in the diagnosing, the processor determines a reference SOH of the contactor corresponding to the operating time of the contactor based on the third reference information, specifies a target SOH range to which the reference SOH belongs among the plurality of SOH ranges, and calculates the third SOH by applying a third weight according to the number of times that the target SOH range is specified to the reference SOH.

19. The contactor diagnosis method of any of clauses 15 to 18, wherein, in the diagnosing, the processor calculates a minimum value among the first to third SOHs as the final SOH of the contactor.

20. A battery management system (BMS) comprising:

a micro controller unit (MCU);
a memory that stores at least one command for execution by the MCU; and
a contactor constituting the BMS,
wherein the MCU diagnoses a deterioration of the contactor based on one or more of a number of times of operation for each power condition, a number of times of operation for each temperature change, and an operating time of the contactor acquired in a process of controlling the contactor.

**Claims**

1. A contactor diagnosis device comprising:

a processor; and
a memory configured to store at least one command for execution by the processor,
wherein the processor is configured to diagnose a deterioration of a contactor based on one or more of a number of times of operation for each power condition of a plurality of power conditions, a number of times of operation for each temperature change of a plurality of temperature changes, and an operating time of the contactor acquired in a process of controlling the contactor constituting a battery management system (BMS).

2. The contactor diagnosis device of claim 1, wherein the processor is configured to calculate first to third states of health (SOHs) of the contactor based on the number of times of operation for each power condition, the number of times of operation for each temperature change, and the operating time, and is configured to calculate a final SOH of the contactor based on a magnitude of each of the calculated first to third SOHs.

3. The contactor diagnosis device of claim 2, wherein:

   first reference information including a plurality of power ranges formed in the contactor when the contactor operates and an allowable number of times of operation mapped to each power range is predefined in the memory; and
   the processor calculates the first SOH based on an actual number of times of operation of the contactor in each power range and the allowable number of times of operation mapped to each power range.

4. The contactor diagnosis device of claim 3, wherein the processor is configured to calculate the first SOH by calculating an SOH for each power range based on a ratio of the actual number of times of operation of the contactor in each power range and the allowable number of times of operation.

5. The contactor diagnosis device of claim 4, wherein:

   the first reference information further includes a first weight mapped to each power range and a first average allowable number of times of operation for a weighted average calculation; and
   the processor is configured to calculate a weighted SOH by calculating a weighted average using a weighted sum result between the actual number of times of operation of the contactor in each power range and the first weight, and the first average allowable number of times of operation, and is configured to calculate a minimum value among the SOH for each power range and the weighted SOH as the first SOH.

6. The contactor diagnosis device of any of claims 2 to 5, wherein:

   second reference information including a plurality of temperature change ranges formed in the contactor when the contactor operates, a second weight mapped to each temperature change range, and a second average allowable number of times of operation for a weighted average calculation is predefined in the memory; and
   the processor is configured to calculate the second SOH by calculating a weighted average using a weighted sum result between an actual number of times of operation of the contactor which caused a temperature change in each temperature change range of the second reference information and the second weight, and the second average allowable number of times of operation.

7. The contactor diagnosis device of any of claims 2 to 6, wherein:

   third reference information including a plurality of SOH ranges according to a set step is predefined in the memory; and
   the processor is configured to calculate the third SOH by determining a reference SOH of the contactor corresponding to the operating time of the contactor based on the third reference information, specifying a target SOH range to which the reference SOH belongs among the plurality of SOH ranges, and applying a third weight according to a number of times that the target SOH range is specified to the reference SOH.

8. The contactor diagnosis device of claim 7, wherein the third weight is differently determined according to a ratio between the number of times that the target SOH range is specified and a reference value mapped to the target SOH range.

9. The contactor diagnosis device of claim 8, wherein, when the ratio between the number of times that the target SOH range is specified and the reference value mapped to the target SOH range is smaller than a set ratio:

   the third weight is determined by a product of (i) the ratio between the number of times that the target SOH range is specified and the reference value mapped to the target SOH range and (ii) the set step, and
   the processor subtracts the third weight from the reference SOH to calculate the third SOH.

10. The contactor diagnosis device of claim 8 or claim 9, wherein, when the ratio between the number of times that the target SOH range is specified and the reference value mapped to the target SOH range is greater than or equal to the set ratio:

    the third weight is determined as a set margin value, and
    the processor adds the set margin value to a lower limit SOH of the target SOH range to calculate the third SOH.

11. The contactor diagnosis device of any of claims 7 to 10, wherein the reference SOH is determined to have a lower value when the operating time of the contactor is larger.

12. The contactor diagnosis device of any of claims 2 to 11, wherein the processor is configured to calculate a minimum value among the first to third SOHs as the final SOH of the contactor.

13. The contactor diagnosis device of any preceding claim, wherein the processor is configured to transmit a deterioration diagnosis result of the contactor to an external device only when a currently received diagnosis information transmission request is authenticated by a predefined authentication key.

14. A contactor diagnosis method comprising:

controlling, by a processor, a contactor constituting a battery management system (BMS);
acquiring, by the processor, operation information of the contactor in a process of controlling the contactor, wherein the operation information includes one or more of a number of times of operation for each power condition of a plurality of power conditions, a number of times of operation for each temperature change of a plurality of temperature changes, and an operating time of the contactor; and
diagnosing, by the processor, a deterioration of the contactor based on the operation information of the contactor.

15. A battery management system (BMS) comprising:

a micro controller unit (MCU);
a memory that stores at least one command for execution by the MCU; and
a contactor constituting the BMS,
wherein the MCU diagnoses a deterioration of the contactor based on one or more of a number of times of operation for each power condition, a number of times of operation for each temperature change, and an operating time of the contactor acquired in a process of controlling the contactor.

# FIG. 1

EP 4 686 952 A1

# FIG. 2

| 300 | 100 | 200 |
|---|---|---|
| CONTACTOR | PROCESSOR | MEMORY |

# FIG. 3

Battery Voltage

$\triangle t$

Current

<Contactor ON>

# FIG. 4

Battery Voltage

Current

$\triangle t$

<Contactor OFF>

# FIG. 5

START

CONTROL OPERATION OF CONTACTOR — S100

ACQUIRE OPERATION INFORMATION OF CONTACTOR — S200

DIAGNOSE DETERIORATION OF CONTACTOR (CALCULATE FINAL SOH (STATE OF HEALTH) OF CONTACTOR) — S300

DETERMINE REMAINING LIFESPAN — S400

RECORD FINAL SOH AND REMAINING LIFESPAN — S500

RECEIVE DIAGNOSIS INFORMATION TRANSMISSION REQUEST — S600

IS AUTHENTICATION KEY STORED IN MEMORY SAME AS AUTHENTICATION KEY OF CURRENTLY RECEIVED DIAGNOSIS INFORMATION TRANSMISSION REQUEST? — S700

N

Y

READ FINAL SOH AND REMAINING LIFESPAN AND TRANSMIT FINAL SOH AND REMAINING LIFESPAN TO EXTERNAL DEVICE — S800

END

# FIG. 6

```
( S200 )
```

CALCULATE SOH FOR EACH POWER CONDITION BASED ON ACTUAL NUMBER OF TIMES OF OPERATION OF CONTACTOR IN EACH POWER RANGE AND ALLOWABLE NUMBER OF TIMES OF OPERATION MAPPED TO EACH POWER RANGE, CALCULATE WEIGHTED SOH BYCALCULATING WEIGHTED AVERAGE USING WEIGHTED SUM RESULT BETWEEN ACTUAL NUMBER OF TIMES OF OPERATION OF CONTACTOR IN EACH POWER RANGE AND FIRST WEIGHT, AND AVERAGE ALLOWABLE NUMBER OF TIMES OF OPERATION, AND CALCULATE MINIMUM VALUE AMONG SOH FOR EACH POWER CONDITION AND WEIGHTED SOH AS FIRST SOH — S310

CALCULATE SECOND SOH BY CALCULATING WEIGHTED AVERAGE USING WEIGHTED SUM RESULT BETWEEN ACTUAL NUMBER OF TIMES OF OPERATION OF CONTACTOR WHICH CAUSED TEMPERATURE CHANGE IN EACH TEMPERATURE CHANGE RANGE AND WEIGHT, AND SECOND AVERAGE ALLOWABLE NUMBER OF TIMES OF OPERATION — S320

DETERMINE REFERENCE SOH OF CONTACTOR CORRESPONDING TO OPERATING TIME OF CONTACTOR, SPECIFY TARGET SOH RANGE TO WHICH REFERENCE SOH BELONGS AMONG PLURALITY OF SOH RANGES, AND CALCULATE THIRD SOH BY APPLYING THIRD WEIGHT ACCORDING TO NUMBER OF TIMES THAT TARGET SOH RANGE IS SPECIFIED TO REFERENCE SOH — S330

CALCULATE MINIMUM VALUE AMONG FIRST TO THIRD SOHS AS FINAL SOH OF CONTACTOR — S340

```
( S400 )
```

Europäisches Patentamt
European Patent Office
Office européen des brevets

# EUROPEAN SEARCH REPORT

**Application Number**

EP 25 18 1550

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/088361 A1 (HARTL DEREK [US] ET AL) 26 March 2015 (2015-03-26) * paragraph [0046] - paragraph [0060]; claim 1; figures 1,3 * | 1-15 | INV. G01R31/327 |
| X | JP 2019 050697 A (MITSUBISHI MOTORS CORP) 28 March 2019 (2019-03-28) * paragraph [0025] - paragraph [0033]; figure 2 * | 1-15 | |
| A | KR 2023 0122950 A (KARAK ELECTRONICS CO LTD [KR]) 22 August 2023 (2023-08-22) * the whole document * | 1-15 | |
| A | US 2023/144978 A1 (BELISLE FRANCIS C [US] ET AL) 11 May 2023 (2023-05-11) * the whole document * | 1-15 | |
| A | CN 209 387 789 U (JIANGSU JIAYUAN TECH CO LTD) 13 September 2019 (2019-09-13) * the whole document * | 1-15 | |
| A | US 2021/096184 A1 (ZENATI ALI [US] ET AL) 1 April 2021 (2021-04-01) * the whole document * | 1-15 | TECHNICAL FIELDS SEARCHED (IPC)<br><br>G01R |
| A | KR 2019 0001254 A (SK INNOVATION CO LTD [KR]) 4 January 2019 (2019-01-04) * the whole document * | 1-15 | |
| A | EP 4 180 885 A1 (FUTURE SYSTEMS BESITZ GMBH [DE]) 17 May 2023 (2023-05-17) * the whole document * | 1-15 | |
| A | CN 117 630 653 A (NANJING JINGYI ELECTRIC POWER NEW ENERGY CO LTD) 1 March 2024 (2024-03-01) * the whole document * | 1-15 | |

-/--

The present search report has been drawn up for all claims

| Place of search | Date of completion of the search | Examiner |
|---|---|---|
| Munich | 15 December 2025 | Meliani, Chafik |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 25 18 1550

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KR 102 432 403 B1 (KOREA ELECTRIC POWER CORP [KR]) 16 August 2022 (2022-08-16) * paragraph [0119] * ----- | 1-15 | |

TECHNICAL FIELDS
SEARCHED       (IPC)

The present search report has been drawn up for all claims

| Place of search | Date of completion of the search | Examiner |
|---|---|---|
| Munich | 15 December 2025 | Meliani, Chafik |

EPO FORM 1503 03.82 (P04C01)

## ANNEX TO THE EUROPEAN SEARCH REPORT
## ON EUROPEAN PATENT APPLICATION NO.

EP 25 18 1550

This annex lists the patent family members relating to the patent documents cited in  the above-mentioned European search report.
The members are as contained in the European Patent Office EDP file on
The European Patent Office is in no way liable for these particulars which are merely given for the purpose of information.

15-12-2025

| Patent document cited in search report | | Publication date | Patent family member(s) | | Publication date |
|---|---|---|---|---|---|
| US 2015088361 | A1 | 26-03-2015 | CN | 104442435 A | 25-03-2015 |
| | | | DE | 102014218927 A1 | 26-03-2015 |
| | | | US | 2015088361 A1 | 26-03-2015 |
| JP 2019050697 | A | 28-03-2019 | NONE | | |
| KR 20230122950 | A | 22-08-2023 | NONE | | |
| US 2023144978 | A1 | 11-05-2023 | EP | 4177923 A1 | 10-05-2023 |
| | | | US | 2023144978 A1 | 11-05-2023 |
| CN 209387789 | U | 13-09-2019 | NONE | | |
| US 2021096184 | A1 | 01-04-2021 | NONE | | |
| KR 20190001254 | A | 04-01-2019 | NONE | | |
| EP 4180885 | A1 | 17-05-2023 | CN | 118647946 A | 13-09-2024 |
| | | | EP | 4180885 A1 | 17-05-2023 |
| | | | EP | 4416559 A1 | 21-08-2024 |
| | | | US | 2025007250 A1 | 02-01-2025 |
| | | | WO | 2023084037 A1 | 19-05-2023 |
| CN 117630653 | A | 01-03-2024 | NONE | | |
| KR 102432403 | B1 | 16-08-2022 | NONE | | |

EPO FORM P0459

For more details about this annex : see Official Journal of the European Patent Office, No. 12/82